# EUROPÄISCHE PATENTSCHRIFT

(11) **EP 2 378 445 B1**
(45) Veröffentlichungstag und Bekanntmachung des Hinweises auf die Patenterteilung: **11.05.2016**
(21) Anmeldenummer: 10159937.1
(22) Anmeldetag: 14.04.2010
(51) Int. Cl.: G06F 17/50, G05B 19/042

(54) **System und Verfahren zur sicherheitstechnischen Planung einer industriellen Anlage mit Gefährdungspotential**
System and method for planning the security of a potentially hazardous industrial facility
Système et procédé de planification de sécurité d'une installation industrielle présentant un potentiel de risque

(43) Veröffentlichungstag der Anmeldung: 19.10.2011
(73) Patentinhaber: Sick AG, 79183 Waldkirch (DE)
(72) Erfinder: Haberer, Manfred, 79359, Riegel (DE)
(74) Vertreter: Ludewigt, Christoph

(56) Entgegenhaltungen:
- EP-A1- 1 785 745
- GB-A- 2 399 192
- MORI K-I: "Renewal Support Services for Manufacturing systems" VTT SYMPOSIUM, [Online] 31. Dezember 2003 (2003-12-31), Seiten 1-13, XP002598324 Gefunden im Internet: URL:http://cic.vtt.fi/projects/globemen/bo ok/14_mori3.pdf> [gefunden am 2010-08-27]

## Beschreibung

Die Erfindung betrifft ein System und ein Verfahren zur sicherheitstechnischen Planung, Konfigurierung und Gefährdungsanalyse einer industriellen Anlage mit Gefährdungspotential.

Für komplexe Maschinen bzw. Fertigungsanlagen gibt es virtuelle Planungs- und Simulationstools, die es den Planern ermöglichen, eine Maschine bzw. Fertigungsanlage so zu planen, dass wesentliche Prozessabläufe in der Simulation validiert und optimiert werden können, ohne dass die Anlage physikalisch aufgebaut bzw. in Betrieb genommen wird. Diese Planungstools berücksichtigen jedoch nicht die sicherheitstechnischen Aspekte, da sie für die eigentliche Funktion der Anlage, beispielsweise das Schweißen einer Karosserie, keine Bedeutung haben.

Um einen Bediener bzw. Einrichter einer industriellen Anlage, beispielsweise einer Abkantpresse, eines Montageroboters, eines Schweißroboters oder dergleichen, vor Verletzungen durch gefährliche Anlagenteile zu schützen, werden in der Regel Schutzmaßnahmen eingebaut, die Unfälle verhindern. Solche Schutzmaßnahmen umfassen z.B. mechanische Schutzzäune oder optische Sicherheitssensoren, wie z.B. fehlersichere Laserscanner oder Lichtgittersysteme, die im einfachsten Fall einen Bereich (Schutzfeld) optisch daraufhin überwachen, ob eine Bedienperson diesen Schutzbereich durch unzulässigen Eingriff verletzt. Wird durch den Sicherheitssensor eine Schutzfeldverletzung detektiert, kann eine Abschaltung des gefährlichen Anlagenteils erfolgen. Diese Sicherheitssensoren müssen vor dem Betrieb durch ein Konfigurationstool an die applikationsspezifischen Gegebenheiten angepasst werden, z.B. muss die Größe des Schutzfeldes parametriert werden, und in einer Inbetriebnahme hinsichtlich der Wirksamkeit überprüft werden. Oft sind den Schutzfeldern Warnfelder vorgelagert, wo Eingriffe zunächst nur zu einer Warnung führen, um den Schutzfeldeingriff und damit die Absicherung noch rechtzeitig zu verhindern und so die Verfügbarkeit der Anlage zu erhöhen.

Wird z.B. mit Hilfe eines Laserscanners die Anwesenheit eines unzulässigen Objektes - also zum Beispiel ein Bein einer Bedienperson - im Gefahrenbereich festgestellt, wird ein Nothalt der Maschine bewirkt. Derartige Sicherheitssensoren müssen zuverlässig arbeiten und deshalb hohe Sicherheitsanforderungen, beispielsweise die Norm EN13849 für Maschinensicherheit und die Gerätenorm EN61496 für berührungslos wirkende Schutzeinrichtungen (BWS), erfüllen.

Solche Sicherheitslaserscanner werden auch an fahrerlosen Transportsystemen (AGV, "Automated Guided Vehicle") eingesetzt, um zu verhindern, dass diese Transportsysteme mit Objekten, die ihren Fahrweg kreuzen, wie z.B. Personen, zusammenstoßen. Da die Zusammenstoßgefahr geschwindigkeitsabhängig ist, weist der Laserscanner anpassbare Schutzfelddimensionen auf, die in Abhängigkeit der Fahrzeuggeschwindigkeit umschaltbar oder in sonstiger Weise veränderbar sind.

Um die Wirksamkeit der Sicherheitssensoren zu überprüfen, müssen diese erst nach vollständigem Aufbau der Anlage zunächst für die entsprechende Anwendung konfiguriert werden und dann im echten Betrieb, also im komplexen Fertigungsablauf getestet und überprüft werden. Solche Fertigungsabläufe können ein komplexer Montageprozess oder auch eine Fahrt eines fahrerlosen Transportsystems sein.

Die Überprüfung erfolgt stichprobenartig und sollte alle erdenklichen Fehler umfassen. Das ist in der Realität aber kaum erfüllbar. So können manche Fehlersituationen nur sehr umständlich überprüft und andere nur unvollständig durchgeführt werden. Beispiel solcher Fehlersituationen sind: Kabelbruch, defekter Sensor, Not-Halt durch Eingreifen, etc.

Manche Fehlersituationen sind nur durch absichtliches Herbeiführen einer gefährlichen Situation prüfbar. Hierzu zählt der unzulässige Eingriff in ein Schutzfeld eines optischen Sensors, beispielsweise eines Sicherheitslaserscanners, der beispielsweise einen Not-Halt eines Anlagenteils zur Folge hat. Dazu muss eine Testperson den Schutzbereich betreten und den Not-Halt provozieren. Dadurch setzt sich die Person immer einer gefährlichen Situation aus. Deshalb erfolgen auch die meisten Unfälle beim Einrichten und Warten einer Anlage und nicht im normalen Betrieb.

Aus den Proceedings zum VTT Symposium 224 "Global Engineering and Manufacturing in Enterprise Networks GLOBEMEN", Helsinki, 9.-10.12.2002, ISBN 951-38-5739-5, Seiten 219-232 ist ein System nach dem Oberbegriff des Anspruchs 1 bzw. ein Verfahren nach dem Oberbegriff des Anspruchs 7 bekannt.

Aufgabe der Erfindung ist es, eine Möglichkeit zur verbesserten Überprüfung und Einrichtung von Sicherheitssensoren bereitzustellen, so dass einerseits die Überprüfung und Einrichtung erleichtert ist und andererseits die Sicherheit für den Einrichter erhöht ist.

Diese Aufgabe wird gelöst durch ein System nach Anspruch 1 sowie ein Verfahren nach Anspruch 7, das dem System entspricht und ein entsprechendes Computerprogramm nach Anspruch 10.

Das erfindungsgemäße System zur sicherheitstechnischen Planung, Konfigurierung und Analyse einer industriellen Anlage mit Gefährdungspotential umfasst einen Computer mit einem Speicher, in dem die Anlage als 3-D Computermodell hinterlegt ist, wobei das Anlagenmodell die Arbeitsbewegungen der Anlage dreidimensional simulieren kann und in dem ein 3-D Computermodell eines Sicherheitssensors im Speicher hinterlegt ist, wobei das Sensormodell einen mittels Konfigurationsparametern umschaltbare Schutzfelder des Sensors umfassenden Erfassungsbereich des Sensors umfasst und in dem ein 3-D Computermodell eines sicherheitskritischen Objektes hinterlegt ist. Das Objektmodell ist über Eingabemittel, z.B. eine Maus oder eine Tastatur, im virtuellen Raum bewegbar und ist in das Schutzfeld des Sensormodells bringbar. Bei derartiger virtueller Verletzung des Schutzfeldes ist weiter eine Reaktion des Sensormodells und insbesondere des Anlagenmodells darstellbar.

Mit einem solchen System ist eine Gefährdungsanalyse der Anlage im virtuellen Betrieb aufgrund der Prozessvisualisierung bzw. Simulation durchführbar, so dass bereits mit Hilfe der Simulation mögliche Maßnahmen, Einstellungen und Konfigurationen definiert werden können, die einen späteren Unfall vermeiden helfen. Diese Maßnahmen, Einstellungen, Konfigurationen können beispielsweise sein:
- korrekte Positionierung von Sicherheitssensoren und optimale Positionierung der Sicherheitslaserscanner im Produktionslayout durch die Möglichkeiten der virtuellen 3D-Anlagensicht,
- korrekte Dimensionierung von Schutzfeldern der Sensoren,
- virtuelle Überprüfung der Anlagenergonomie für den Bediener im Zusammenspiel mit der Sicherheitseinrichtung für optimierte Produktivität,
- Überprüfung aller Anlagenzustände im virtuellen Funktionsablauf mit zeitlichem Abgleich erforderlicher Umschaltungen von Schutzfeldern,
- Simulation des Systemverhaltens bei Ansprechen der Sicherheitsfunktion und anschließendem Wiederanlauf der Maschine bis zur vollen Produktionsgeschwindigkeit,
- Finden von Abschattungen,
- Auflösungen im Schutzfeld,
- Fehleranzeigen,
- Sensorausgangssignale im Fehlerfall,
und dergleichen vieles mehr.

Gefundene Parameter können abgespeichert und von dem System an den realen Sicherheitssensor übertragen werden.

Durch die Erfindung ist es somit möglich, optische Sicherheitssensoren in einem virtuellen Planungs- und Simulationstool zu integrieren und die kompletten sicherheitstechnischen Aufgaben in dem Simulationstool auszuführen. So kann mit der Erfindung ein System und ein Verfahren bereitgestellt werden, in dem es möglich ist, die Gefahrenanalyse, Planung, Projektierung, Inbetriebnahme, Überprüfung und Konfigurationseinstellungen der sicherheitstechnischen Komponenten einfach und ohne Gefährdung des Einrichters vorzunehmen. Dabei werden die normativen Anforderungen in der Simulation verifiziert und die Reaktion auf Fehler bzw. das Systemverhalten, z.B. das Bremsverhalten eines AGV bei max. Beladung oder die Anhaltewegstrecke eines Roboters bei max. Last am TCP (Tool Center Point), überprüft.

Die Erfindung ermöglicht es dem Steuerungstechniker, das virtuelle Modell der Maschine oder Arbeitszelle zu nutzen, um verschiedene Gefahrensituationen, die ansonsten nur schwer zu beurteilen sind, in Szenarien zu analysieren. Beispielsweise kann mit der Erfindung relativ schnell, einfach und gefahrlos die Frage beantwortet werden, was bei Umstellung einer Fertigungslinie von Produkt A auf Produkt B in Bezug auf sicherheitstechnische Fragen passiert? Auftretende Probleme können vorab erkannt werden und Lösungen gefunden werden. Bereits Wochen vor der Integration sämtlicher Komponenten und Systeme ist der Steuerungstechniker in der Lage, alle Fehlerbedingungen zu testen. Das erspart kostspielige Ausfallzeiten in der Produktion.

Dabei ist vorgesehen, dass das Sensormodell Konfigurationsparameter umfasst, um z.B. Schutzfelddimensionierungen oder Schutzfeldausrichtungen anpassen zu können.

Weitere Merkmale sind Gegenstand der abhängigen Ansprüche.

In Weiterbildung der Erfindung ist vorgesehen, dass die Konfigurationsparameter denen des realen Sensors entsprechen und veränderbar sind.

Bevorzugt weist das Sensormodell umschaltbare Schutzfelder auf, die mittels der Konfigurationsparameter umschaltbar sind.

Um dynamische Änderungen berücksichtigen zu können, ist in Weiterbildung der Erfindung vorgesehen, dass die Konfigurationsparameter dynamisch während einer Arbeitsbewegung des Anlagenmodells veränderbar sind.

Wenn das Sensormodell Fehlerparameter umfasst, mittels derer sicherheitstechnische Fehler simulierbar sind, und eine Reaktion des Sensormodells und des Anlagenmodells auf die Fehler darstellbar ist, können mögliche Fehler simuliert und deren Folgen erkannt werden.

Wenn die Schutzfelder des Sensormodells grafisch darstellbar sind, können diese in einfacher Weise auch grafisch, z.B. mittels Ziehen mit einer Computermaus, schnell und einfach in ihren Dimensionen verändert und angepasst werden.

Die Eigenschaften des Sensormodells und des Objektmodells sollten den Anforderungen von Sicherheitsnormen entsprechen, so dass die mittels der mit dem erfindungsgemäßen System eingerichtete Anlage auch normenkonform ist. Wenn das Sensormodell als Programmmodul ausgebildet ist, kann es in einfacher Weise als "plug-in" in ein vorhandenes Planungstool integriert werden.

Das erfindungsgemäße Verfahren entspricht dem beschriebenen System und ist als Computerprogramm mit Programmcodemitteln zum Durchführen des Verfahrens realisiert. Das Computerprogramm kann auf einem Speichermedium gespeichert sein.

Im Folgenden wird die Erfindung anhand eines Ausführungsbeispiels unter Bezugnahme auf die Zeichnung im Einzelnen erläutert:

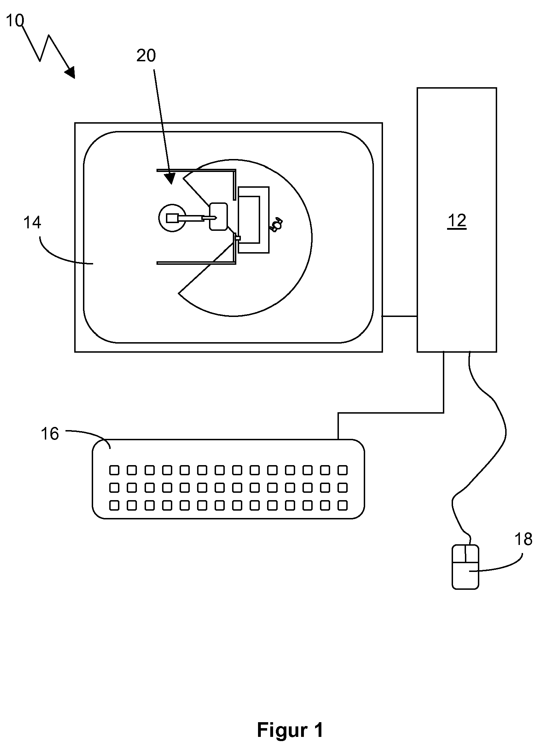

- Fig. 1: eine Ausführungsform des erfindungsgemäßen Systems;
- Fig. 2: eine schematische Darstellung einer Draufsicht auf eine graphische Darstellung einer simulierten Anlage;
- Fig. 3: die Anlage aus Fig. 2 in der Seitenansicht.

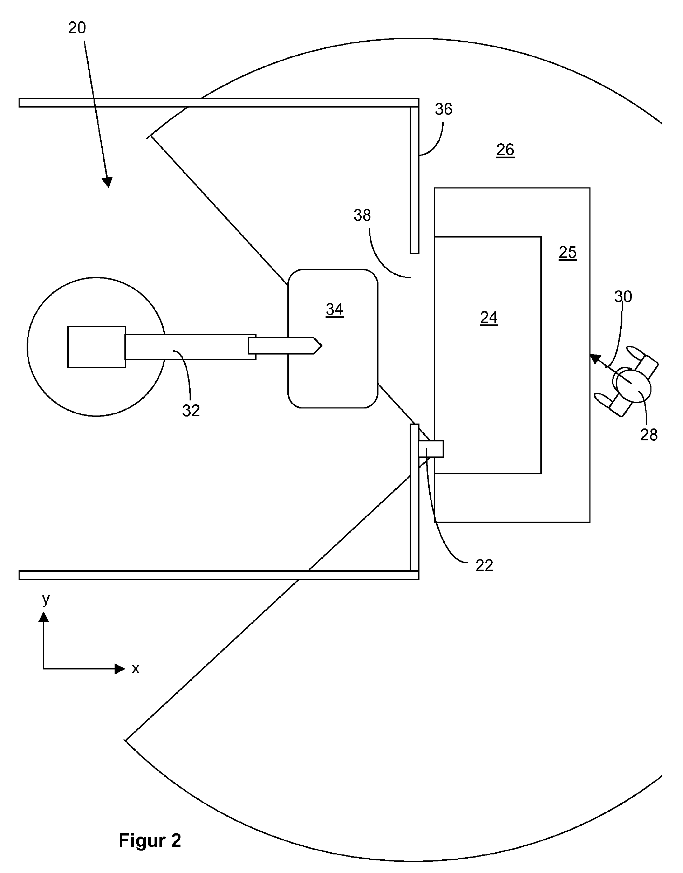

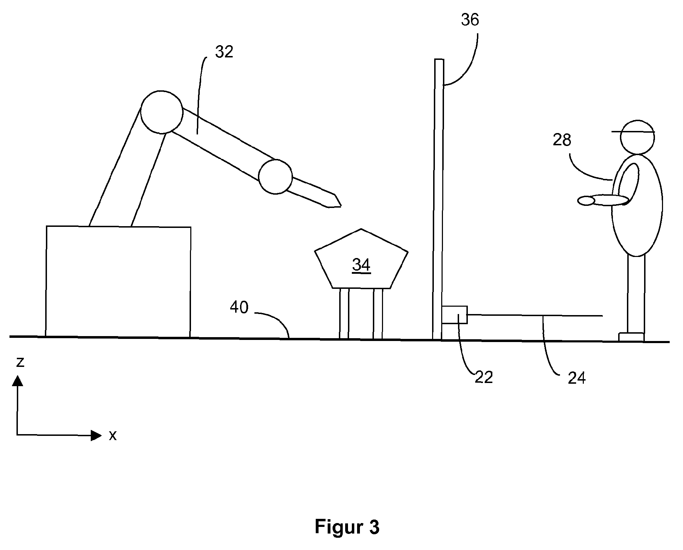

Das erfindungsgemäße System 10 zur sicherheitstechnischen Planung, Konfigurierung und Analyse einer industriellen Anlage mit Gefährdungspotential umfasst einen Computer 12 mit einem Bildschirm 14, einer Tastatur 16 und einer Computermaus 18. In einem Speicher des Computers ist eine industrielle Anlage 20 als 3-D Computermodell hinterlegt. Eine solche Anlage 20 ist in Fig. 2 und 3 dargestellt. Es kann sich z.B. um einen Montageroboter, Schweißroboter, Abkantpresse oder dergleichen Maschine handeln. Das Anlagenmodell ist so ausgebildet, dass die Arbeitsbewegungen der Anlage 20 dreidimensional im Computer simuliert werden können. Des Weiteren ist in dem Speicher ein 3-D Computermodell eines Sicherheitssensors 22 hinterlegt, wobei das Sensormodell einen ein Schutzfeld 24 und ein Warnfeld 25 des Sensors 22 umfassenden Erfassungsbereich 26 des Sensors 22 umfasst. Ebenfalls ist ein 3-D Computermodell eines sicherheitskritischen Objektes 28 hinterlegt, das hier als Person 28 dargestellt ist. Das Objektmodell 28 ist über Eingabemittel, z.B. die Maus 18 oder die Tastatur 16, im virtuellen Raum bewegbar (Pfeil 30).

In dem Ausführungsbeispiel umfasst die Anlage 20 einen Roboter 32, ein vom Roboter zu bearbeitendes Werkstück 34 und einen Schutzzaun 36.

Im Folgenden soll das erfindungsgemäße Verfahren anhand der schematischen Darstellungen der Fig. 2 und 3 erläutert werden.

Das Verfahren dient zur sicherheitstechnischen Planung, Konfigurierung und Analyse der industriellen Anlage 20. Das 3-D Anlagenmodell umfast den Roboter 32, das vom Roboter zu bearbeitende Werkstück 34 und den Schutzzaun 36. In der dargestellten Simulation, die in der Regel auf dem Bildschirm 14 dargestellt wird, sind alle Arbeitsbewegungen der Anlage 20 dreidimensional simulierbar.

Es könnte nun beispielsweise die Aufgabe für einen Planer bestehen, den Durchgang 38 mit dem Sicherheitssensor 22 abzusichern, so dass der Durchgang 38 nur dann für eine Person 28 frei zugänglich ist, wenn der Roboter 32 sich in einem gefahrlosen Zustand befindet. Dazu wird zunächst der Sensor 22 an eine geeignete Position im Raum positioniert und ausgerichtet. In diesem Beispiel am Rande des Durchgangs 38 knapp oberhalb des Bodens 40. Dann müssen entsprechende Schutzfelder 24 und 25 innerhalb des Erfassungsbereichs 26 des Sensors 22 definiert, dimensioniert und ausgerichtet werden, was z.B. durch Ziehen mit der Maus 18 erfolgen könnte. Des weiteren muss in einer nicht dargestellten Kommunikationsmöglichkeit, beispielsweise über die Tastatur 16, dem System 10 die Sicherheitsinformationen eingegeben werden, die darin bestehen könnten festzulegen, wie die Anlage reagieren soll, wenn das Schutzfeld 24 und das Warnfeld 25 verletzt werden. Eine mögliche Konfiguration wäre z.B., dass bei Verletzung des Warnfeldes 25 lediglich eine Verlangsamung des Roboters 32 erfolgt und bei Verletzung des Schutzfeldes 24 ein Not-Halt des Roboters 32.

Nun kann ein möglicher Sicherheitstest darin bestehen, das Objektmodell 28 in das Warnfeld 25 oder in das Schutzfeld 24 zu bewegen, so dass Warn- und Schutzfeld verletzt werden und dann die Reaktionen des Sensormodells 22 und des Anlagenmodells 20, die im Computer errechnet und auf dem Bildschirm dargestellt werden, zu beobachten und zu beurteilen. Sind die Reaktionen in sicherheitstechnischer Hinsicht falsch, wenn z.B. der Roboter 32 keinen Not-Halt bei Schutzfeldverletzung durchführt, dann wird die Konfiguration als unzulässig klassifiziert und muss mit geänderten Konfigurationsparametern neu vorgenommen werden. Dazu müssen die Konfigurationsparameter selbstverständlich veränderbar sein.

Auf diese Weise können die verschiedensten, eingangs beispielhaft aufgezählten Maßnahmen, Einstellungen, Konfigurationen und Fehlersituationen durchgespielt und geprüft werden, bis schließlich eine sicherheitstechnisch unbedenkliche und den Sicherheitsnormen entsprechende Auslegung gefunden ist.

Ein typisches Beispiel für eine solche Prüfung wäre z.B. auch die korrekte Umschaltung von Schutzfeldern 24. Wenn z.B. der Sensor 22 verschiedene Schutzfelder 24, mit jeweils unterschiedlichen Dimensionen, aktivieren soll und zwar abhängig von der Position des Roboters 32. Ist der Roboter 32 weit entfernt vom Durchgang 38 kann ein kleines Schutzfeld 24 aktiviert sein, wohingegen ein größeres Schutzfeld 24 aktiv sein sollte, wenn der Roboter nahe am Durchgang ist. Konfigurationsparameter, die die Schutzfeldgröße definieren, müssten dafür dynamisch während einer Arbeitsbewegung des Roboters 32 veränderbar sein. Die korrekte Konfiguration kann dann mit dem erfindungsgemäßen Verfahren und System in einfachster Weise grafisch auf dem Bildschirm 14 geprüft werden.

Die Konfigurationsparameter für den Sensor 22, die einer mit dem erfindungsgemäßen Verfahren und System gefundenen sicherheitstechnisch normenkonformen Konfiguration entsprechen, sind dann aus der Simulation heraus an den realen Sensor übermittelbar und müssen nicht noch einmal separat in den Sensor eingegeben werden.

## Patentansprüche

1. System zur sicherheitstechnischen Planung, Konfigurierung und Analyse einer industriellen Anlage (20) mit Gefährdungspotential, mit einem Computer (12), wobei die Anlage als 3-D Computermodell in einem Speicher des Computers hinterlegt ist, wobei das Anlagenmodell die Arbeitsbewegungen der Anlage (20) dreidimensional simulieren kann, und ein 3-D Computermodell eines Sicherheitssensors (22) sowie ein 3-D Computermodell eines sicherheitskritischen Objektes (28) im Speicher hinterlegt sind, **dadurch gekennzeichnet, dass** das Sensormodell einen Erfassungsbereich (26) des Sensors umfasst, der grafisch darstellbare Schutzfelder (24, 25) umfasst, die mittels Konfigurationsparametern in ihren Dimensionierungen oder Ausrichtungen anpassbar und umschaltbar sind, wobei das Objektmodell über Eingabemittel (16, 18) im virtuellen Raum bewegbar ist und in ein Schutzfeld (24, 25) des Sensormodells (22) bringbar ist, und bei derartiger Verletzung des Schutzfeldes (24, 25) eine Reaktion des Sensormodells (22) und des Anlagenmodells (20) darstellbar ist.

2. System nach Anspruch 1, **dadurch gekennzeichnet, dass** die Konfigurationsparameter denen des realen Sensors entsprechen und veränderbar sind.

3. System nach einem der vorhergehenden Ansprüche, **dadurch gekennzeichnet, dass** die Konfigurationsparameter dynamisch während einer Arbeitsbewegung des Anlagenmodells veränderbar sind.

4. System nach einem der vorhergehenden Ansprüche, **dadurch gekennzeichnet, dass** das Sensormodell Fehlerparameter umfasst, mittels derer sicherheitstechnische Fehler simulierbar sind, und eine Reaktion des Sensormodells und des Anlagenmodells auf die Fehler darstellbar ist.

5. System nach einem der vorhergehenden Ansprüche, **dadurch gekennzeichnet, dass** die Eigenschaften des Sensormodells und des Objektmodells die Anforderungen von Sicherheitsnormen simulieren.

6. System nach einem der vorhergehenden Ansprüche, **dadurch gekennzeichnet, dass** das Sensormodell als Programmmodul zur Verfügung steht.

7. Verfahren zur sicherheitstechnischen Planung, Konfigurierung und Analyse einer industriellen Anlage mit Gefährdungspotential mit einem System nach einem der vorhergehenden Ansprüche, bei dem mit einem Computer ein 3-D Computermodell der Anlage dargestellt wird, das die Arbeitsbewegungen der Anlage dreidimensional simulieren kann, ein 3-D Computermodell eines Sicherheitssensors dargestellt wird und ein 3-D Computermodell eines sicherheitskritischen Objektes dargestellt wird und bei Simulierung von sicherheitstechnischen Fehlfunktionen am Sensormodell eine Reaktion des Anlagenmodells im Computer errechnet und dargestellt wird, **dadurch gekennzeichnet, dass** mittels Konfigurationsparametern dimensionierbare, ausrichtbare und umschaltbare Schutzfelder des Sensors grafisch dargestellt werden und dass das Objekt im virtuellen Raum bewegbar und in ein Schutzfeld des Sensormodells bringbar ist und bei derartiger Verletzung des Schutzfeldes eine Reaktion des Sensormodells darstellbar ist.

8. Verfahren nach Anspruch 7, **dadurch gekennzeichnet, dass** mit der Simulation geeignete Konfigurationsparameter für das Sensormodell gefunden werden und die nach der Simulation an den realen Sensor übermittelt werden.

9. Computerprogramm mit Programmcodemitteln zum Durchführen eines Verfahrens nach Anspruch 7 oder 8.

10. Computerprogrammprodukt mit einem Speichermedium auf dem ein Computerprogramm nach Anspruch 9 gespeichert ist.

## Claims

1. System for safety planning, configuration and analysis of an industrial facility (20) with a risk potential, with a computer (12), wherein the facility is stored as a 3-D computer model in a memory of the computer, wherein the facility model can simulate three-dimensionally the working movements of the facility (20), and a 3-D computer model of a safety sensor (22) and a 3-D computer model of a safety-critical object (28) are stored in the memory, **characterized in that** the sensor model includes a detection area (26) of the sensor which comprises graphically displayable protective fields (24, 25) which can be adapted and switched in their dimensions or orientations by means of configuration parameters, wherein the object model can be moved in the virtual space via input means (16, 18) and can be brought in a protected area (24, 25) of the sensor model (22), and at such infringement of the protective field (24, 25) a reaction of the sensor model (22) and the facility model (20) is displayable.

2. System according claim 1, **characterized in that** the configuration parameters correspond to those of the real sensor and which are changeable.

3. System according to any one of the preceding claims, **characterized in that** the configuration parameters are changeable dynamically during a working motion of the facility model.

4. System according to any preceding claim, **characterized in that** the sensor model includes error parameters by which safety related errors can be simulated and a response of the sensor model and the facility model to the errors is displayed.

5. System according to any one of the preceding claims, **characterized in that** the properties of the sensor model and of the object model simulate the requirements of safety standards.

6. System according to any one of the preceding claims, **characterized in that** the sensor model is available as a program module.

7. Method for safety planning, configuration and analysis of an industrial facility with a risk potential with a system according to any preceding claim in which a computer displays a 3-D computer model of the system, which model can simulate the working movements of the facility in three dimensions, a 3-D computer model of a safety sensor is displayed and a 3-D computer model of a safety-critical object is represented and a reaction of the facility model is calculated and displayed by the computer when simulating safety failures at the sensor model, **characterized in that** protection zones of the sensor are displayed graphically which are dimensionable, adjustable and switchable by means of configuration parameters, and in the object is movable and can be brought into a detection zone of the sensor model in the virtual space and in case of such an infringement of the protective field a reaction of the sensor model is displayable.

8. Method according to claim 7, **characterized in that** appropriate configuration parameters for the sensor model are found with the simulation and which parameters are transmitted to the real sensor after the simulation.

9. Computer program having program code means for performing a method according to claim 7 or 8.

10. Computer program product comprising a storage medium on which a computer program according to claim 9 is stored.

## Revendications

1. Système pour la planification de la sécurité, la configuration et l'analyse d'une installation industrielle (20) avec un potentiel de risque, avec un ordinateur (12), dans lequel l'installation est stockée dans une mémoire de l'ordinateur sous la forme d'un modèle informatique 3-D, dans lequel le modèle de l'installation permet de simuler en trois dimensions les déplacements de travail de l'installation (20), et un modèle informatique 3D d'un capteur de sécurité (22) ainsi qu'un modèle informatique 3D d'un objet critique pour la sécurité (28) sont stockés dans la mémoire, **caractérisé en ce que** le modèle de capteur comprend une zone de détection (26) du capteur qui comprend des champs de protection sous forme graphique visualisable (24, 25) qui peuvent être adaptés et commutés dans leurs dimensions ou orientations au moyen de paramètres de configuration, dans lequel l'objet modèle peut être déplacé dans l'espace virtuel par l'intermédiaire des moyens d'entrées (16, 18) et peut être amené dans une zone protégée (24, 25) du modèle de capteur (22), et à cette violation du champ de protection (24, 25) une réaction du modèle de capteur (22) et le modèle de l'installation (20) est affichable.

2. Système selon la revendication 1, **caractérisé en ce que** les paramètres de configuration correspondent à ceux du capteur réel et sont modifiables.

3. Système selon l'une des revendications précédentes, **caractérisé en ce que** les paramètres de configuration sont modifiables dynamiquement au cours d'un mouvement de travail du modèle d'installation.

4. Système selon l'une des revendications précédentes, **caractérisé en ce que** le modèle de capteur comprend des paramètres d'erreur par lesquels des erreurs liés à la sécurité peuvent être simulés et une réponse du modèle de capteur et du modèle de l'installation aux erreurs est affiché.

5. Système selon l'une des revendications précédentes, **caractérisé en ce que** les propriétés du modèle de capteur et du modèle d'objet simulent les exigences des normes de sécurité.

6. Système selon l'une des revendications précédentes, **caractérisé en ce que** le modèle de capteur est disponible en tant que module de programme.

7. Procédé pour la planification de la sécurité, la configuration et l'analyse d'une installation industrielle avec un potentiel de risque avec un système selon l'une des revendications précédentes, dans lequel un ordinateur affiche un modèle informatique 3D du système, le modèle peut simuler en trois dimensions les déplacements de travail de l'installation, un modèle informatique 3D d'un capteur de sécurité est affiché et un modèle informatique 3D d'un objet critique pour la sécurité est affiché et une réaction du modèle d'installation est calculée et affichée par l'ordinateur lors de la simulation les défaillances de sécurité au modèle de capteur, **caractérisé en ce que** les zones de protection du capteur qui sont dimensionnables, réglables et commutables sont affichés sous forme graphique au moyen de paramètres de configuration, et que l'objet peut être déplacé dans l'espace virtuel et peut être amené dans une zone protégée du modèle de capteur, et à cette violation du champ de protection une réaction du modèle de capteur (22) est affichable.

8. Procédé selon la revendication 7, **caractérisé en ce que** des paramètres de configuration appropriés pour le modèle de capteur se trouvent avec la simulation et qui sont transmis au capteur réel après la simulation.

9. Programme informatique comportant des moyens de code de programme pour réaliser un procédé selon la revendication 7 ou 8.

10. Produit de programme informatique comprenant un support de stockage sur lequel un programme informatique est stocké selon la revendication 9.
